# EUROPÄISCHE PATENTSCHRIFT

(11) **EP 2 348 638 B1**
(45) Veröffentlichungstag und Bekanntmachung des Hinweises auf die Patenterteilung: **20.04.2016**
(21) Anmeldenummer: 11000470.2
(22) Anmeldetag: 21.01.2011
(51) Int. Cl.: H03K 17/955, H03K 17/96

(54) **Kapazitiver Berührungs- und/oder Annäherungsschalter**
Capacitive contact and/or proximity switch
Commutateur de contact et/ou de rapprochement capacitif

(30) Priorität: 26.01.2010 DE 102010005663
(43) Veröffentlichungstag der Anmeldung: 27.07.2011
(73) Patentinhaber: Diehl AKO Stiftung & Co. KG, 88239 Wangen (DE)
(72) Erfinder: Heimann, Uwe, 88239 Wangen (DE); Golz, Dirk, 88212 Ravensburg (DE)
(74) Vertreter: Diehl Patentabteilung

(56) Entgegenhaltungen:
- DE-A1-102006 035 837
- GB-A- 2 459 888
- US-A1- 2008 140 282
- US-B2- 7 525 062

## Beschreibung

Die vorliegende Erfindung betrifft einen kapazitiven Berührungs- und/oder Annäherungsschalter nach dem Oberbegriff des Anspruches 1, eine Bedienvorrichtung mit einem solchen kapazitiven Berührungs- und/oder Annäherungsschalter sowie ein Verfahren zu seiner Herstellung.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig berührungsempfindliche Tastschalter bzw. Berührungs- und/oder Annäherungsschalter eingesetzt, die durch ein einfaches Berühren oder bloßes Annähern durch einen Benutzer zum Beispiel einen bestimmten Schaltvorgang auslösen und/oder eine Geräteeinstellung ändern.

Im Fall eines kapazitiven Berührungs- und/oder Annäherungsschalters bildet ein kapazitives Sensorelement aus einem elektrisch leitfähigen Material zusammen mit zum Beispiel einem Finger des Benutzers über eine als Dielektrikum wirkende Abdeckplatte aus einem elektrisch isolierenden Material eine Kapazität, die entsprechend dem Betätigen des Schalters, d.h. dem Berühren oder Nicht-Berühren eines dem kapazitiven Sensorelement zugeordneten Berührungsfeldes der Abdeckplatte variabel ist. Die Veränderung des Kapazitätswertes des kapazitiven Sensorelementes wirkt sich entsprechend auf ein Ausgangssignal der Sensorschaltung aus, welches von einer Auswerteelektronik verarbeitet und ausgewertet werden kann, um ggf. eine Betätigung des kapazitiven Berührungs- und/oder Annäherungsschalters zu interpretieren.

Bei herkömmlichen kapazitiven Berührungs- und/oder Annäherungsschaltern, wie sie zum Beispiel aus der DE 10 2005 053 792 A1 oder der WO 2006/034993 A1 bekannt sind, sind die Auswerteelektronik für die Sensorschaltung und auch das kapazitive Sensorelement auf einer Leiterplatte montiert, die im Wesentlichen parallel und in einem Abstand hinter der Abdeckplatte angeordnet ist. Dabei besteht das Sensorelement aus einem Sensorabschnitt bzw. einer Sensorfläche, der/die über einen elektrisch leitfähigen Körper in Form einer Druckfeder mit einem elektrisch leitenden Kontakt auf der Leiterplatte verbunden ist. Ein derartiger Berührungs- und/oder Annäherungsschalter, der in Berührungsrichtung verschiebbar ist, ist auch aus der DE 10 2006 035 837 A1 bekannt.

Ein anderer Berührungs- und/oder Annäherungsschalter ist aus der US 7,525,062 B2 bekannt. Dieser Berührungs- und/oder Annäherungsschalter beschreibt ein an einer Bedienblende befestigtes Sensorelement aus leitfähigem Kunststoff, das dazu ausgestaltet ist, eine Leiterplatte zu haltern.

Aus der GB 2 459 888 A ist ein weiterer solcher Berührungsschalter bekannt, der ein Lichtleitelement aufweist, über das eingekoppeltes Licht zu einem Berührungsfeld geleitet wird, um dieses zu beleuchten.

Bei sehr kleinen Bedienblendenflächen, die zum Beispiel nur Platz für eine Reihe weniger Schaltelemente haben, existiert hinter der Abdeckplatte dann bei diesen vorgenannten Konstruktionen nicht genügend Raum für die Leiterplatte mit Auswerteelektronik. Solche Einbauverhältnisse existieren zum Beispiel bei Bedienblenden, die in der Stirnseite einer Tür eines Haushaltsgerätes vorgesehen sind.

Für den Fall von Bedienvorrichtungen mit gekrümmten Abdeckplatten schlägt die EP 1 924 000 A2 die Verwendung flexibler Leiterplattenteile vor. Ein solcher flexibler Leiterplattenabschnitt kann mit mehreren Berührungsschaltern und Anzeigeelementen versehen und unmittelbar hinter der gekrümmten Abdeckplatte angeordnet werden. Dieser flexible Leiterplattenabschnitt ist ferner mit einer steifen Leiterplatte verbunden, die zum Beispiel mit einem Display und einer Auswerteelektronik bestückt und in irgendeiner Ausrichtung hinter der Abdeckplatte angeordnet sein kann.

Es ist die Aufgabe der vorliegenden Erfindung, einen kapazitiven Berührungs- und/oder Annäherungsschalter zu schaffen, der auch im Fall sehr kleiner Bedienblendenflächen eingesetzt werden kann.

Diese Aufgabe wird gelöst durch einen kapazitiven Berührungs- und/oder Annäherungsschalter mit den Merkmalen des Anspruches 1. Bevorzugte Ausführungsformen und Weiterentwicklungen sind Gegenstand der abhängigen Ansprüche 2 bis 10.

Der kapazitive Berührungs- und/oder Annäherungsschalter weist eine elektrisch isolierende Abdeckplatte, die ein Berührungsfeld für einen Benutzer definiert; eine auf einer dem Benutzer abgewandten Seite der Abdeckplatte angeordnete Trägerplatte; ein elektrisch leitfähiges Sensorelement; und eine Auswerteelektronik, welche elektrisch leitend mit dem Sensorelement verbunden ist, auf. Dabei weist das Sensorelement einen Sensorabschnitt, der auf der dem Benutzer abgewandten Seite der Abdeckplatte korrespondierend zu dem Berührungsfeld und im Wesentlichen parallel zu der Abdeckplatte angeordnet ist, sowie einen Kontaktabschnitt zum Befestigen des Sensorelementes an der Trägerplatte auf, wobei die Auswerteelektronik über den Kontaktabschnitt elektrisch leitend mit dem Sensorelement verbunden ist, wobei vorgesehen ist, dass das Sensorelement mit der Trägerplatte verbunden ist und die Trägerplatte in einem Winkel von etwa 30 Grad bis zu etwa 90 Grad zur Abdeckplatte angeordnet ist und der Kontaktabschnitt des Sensorelementes zur Ausrichtung des Sensorabschnittes des Sensorelementes gegenüber der Trägerplatte in einem Winkel von etwa 30 Grad bis zu etwa 90 Grad ausgebildet ist.

Bei dem erfindungsgemäßen Berührungs- und/oder Annäherungsschalter ist die Trägerplatte in einem Winkel von über etwa 30 Grad zur Abdeckplatte, d.h. nicht parallel zu dieser angeordnet. Die (groß)winklige Anordnung der Trägerplatte relativ zur Abdeckplatte liegt in einem Bereich von etwa 30 Grad bis zu etwa 90 Grad, d.h. einer senkrechten Anordnung der Trägerplatte. Ein sinnvoller Einsatz des erfindungsgemäßen Berührungs- und/oder Annäherungsschalters ergibt sich insbesondere bei Winkeln ab etwa 45 Grad oder etwa 60 Grad. Durch diese nicht parallele Anordnung der Trägerplatte relativ zur Abdeckplatte benötigt die Trägerplatte in den Ausbreitungsrichtungen parallel zur Abdeckplatte weniger Bauraum. Auf diese Weise kann der Berührungs- und/oder Annäherungsschalter auch bei Bedienvorrichtungen mit kleinen Bedienblendenflächen eingesetzt werden, da die Trägerplatte hinter diesen kleinen Bedienblendenflächen angeordnet werden kann. Dabei ist der Kontaktabschnitt des Sensorelementes zur Ausrichtung des Sensorabschnittes des Sensorelementes gegenüber der Trägerplatte in einem Winkel von über etwa 30 Grad ausgebildet.

Um diese (groß)winklige Anordnung der Trägerplatte gegenüber der Abdeckplatte realisieren zu können, ist der Kontaktabschnitt des Sensorelementes so ausgebildet, dass er eine Ausrichtung des Sensorabschnittes des Sensorelementes gegenüber der Trägerplatte ebenfalls in einem Winkel von über etwa 30 Grad ermöglicht. Dieser Winkel entspricht im Wesentlichen dem Winkel zwischen der Abdeckplatte und der Trägerplatte und es gelten die obigen Anmerkungen in entsprechender Weise.

Im Gegensatz zu den herkömmlichen kapazitiven Tastschaltern, bei denen der Sensorabschnitt des kapazitiven Sensorelementes im Wesentlichen parallel zur Trägerplatte verläuft und sich das Kontaktelement des Sensorelementes (z.B. in Form einer Druckfeder) im Wesentlichen senkrecht zwischen dem Sensorabschnitt des Sensorelementes und der Trägerplatte erstreckt, ist der elektrisch leitfähige Kontaktabschnitt des Sensorelementes bei dem erfindungsgemäßen Berührungs- und/oder Annäherungsschalter so ausgebildet, dass er eine (groß) winklige Anordnung des Sensorabschnittes des Sensorelementes gegenüber der Trägerplatte ermöglicht. Durch diese Konstruktion des Kontaktabschnittes des Sensorelementes entsteht ein Freiheitsgrad für die Anordnung der Trägerplatte in der oben beschriebenen, nicht parallelen Ausrichtung relativ zur Abdeckplatte.

Es ist denkbar, den durch den Kontaktabschnitt ermöglichten Winkel zwischen dem Sensorabschnitt des Sensorelementes und der Trägerplatte variabel einstellbar zu gestalten, sodass das gleiche Sensorelement für verschiedene Ausführungsformen des Schalters mit unterschiedlichen Winkeln zwischen Abdeckplatte und Trägerplatte eingesetzt werden kann.

Im Rahmen der vorliegenden Erfindung kann die "Trägerplatte" zum Beispiel eine Leiterplatte oder eine Kunststoffplatte sein. Die Trägerplatte kann außerdem als ein stabiler Plattenkörper ausgebildet sein oder nur Folienstärke aufweisen.

In Zusammenhang mit der vorliegenden Erfindung dient die "Auswerteelektronik" dem Verarbeiten und Auswerten der von der Sensorschaltung erzeugten Ausgangssignale, um ein Betätigen des Schalters durch ein Berühren/Annähern bzw. Nicht-Berühren/Annähern festzustellen. Von dieser Auswerteelektronik zu unterscheiden ist die Steuerung z.B. des Haushaltsgerätes, mit welcher die Auswerteelektronik verbunden ist und welche wahlweise wie die Auswerteelektronik auf der Trägerplatte oder an einer anderen Stelle im Haushaltsgerät angeordnet sein kann. In einigen Anwendungen kann die Auswerteelektronik auch in diese Steuerung integriert sein.

Das "elektrisch leitfähige Sensorelement" besteht im Wesentlichen aus dem Sensorabschnitt und dem Kontaktabschnitt. Vorzugsweise sind diese beiden Abschnitte integral ausgebildet; zum Beispiel kann das Sensorelement als ein Stanzbiegeteil gefertigt werden. Außerdem sind beide Abschnitte aus einem elektrisch leitfähigen Material gefertigt, um die Funktion des kapazitiven Sensorelementes und seine Verbindung mit der Auswerteelektronik zu gewährleisten.

Der Kontaktabschnitt des Sensorelementes kann aus einem einzigen Abschnitt oder mehreren Teilabschnitten bestehen, er kann geradlinig oder ein- oder mehrfach gekrümmt bzw. gebogen sein. Die Veränderung einer solchen Krümmung im Fertigungsprozess kann zum Beispiel den oben genannten variabel einstellbaren Winkel zwischen dem Sensorabschnitt und der Trägerplatte erreichen. In einer alternativen Ausführungsform kann der Kontaktabschnitt durch einen Teil des Sensorabschnitts gebildet sein.

Der Sensorabschnitt des Sensorelementes ist "korrespondierend zu dem Berührungsfeld" der Abdeckplatte angeordnet. Im Rahmen dieser Erfindung bedeutet dies, dass die Dimensionierung, die Form und die Platzierung des Sensorelementes hinter der Abdeckplatte die Dimensionierung, die Form bzw. die Position des Berührungsfeldes auf der Abdeckplatte bestimmen. Das Berührungsfeld kann für den Benutzer auf der Abdeckplatte zusätzlich optisch und/oder haptisch gekennzeichnet sein, um die Bedienung durch den Benutzer zu vereinfachen.

Der elektrisch leitfähige Sensorabschnitt des Sensorelementes ist in seinen Abmessungen, Formen und Gestaltungen grundsätzlich beliebig auszugestalten und kann an den jeweiligen Anwendungsfall ohne Beschränkungen angepasst werden. Es sind hier zum Beispiel vollflächige Sensorabschnitte oder Sensorabschnitte mit Aussparungen wie zum Beispiel ringförmige, U-förmige, o.ä. Sensorabschnitte denkbar.

Die "elektrisch isolierende" Ausbildung der Abdeckplatte soll in Zusammenhang mit der vorliegenden Erfindung bedeuten, dass die Abdeckplatte zumindest im Bereich des Berührungsfeldes elektrisch isolierend ausgebildet ist, sodass sie in diesem Bereich als ein Dielektrikum für das kapazitive Sensorelement dienen kann. Andere Bereiche der Abdeckplatte können durchaus elektrisch leitfähig ausgebildet sein.

Der Begriff der "Baueinheit" soll eine im Fertigungsprozess des Berührungs- und/oder Annäherungsschalters vormontierbare Einheit aus mehreren Komponenten bezeichnet. Diese vormontierte Baueinheit kann dann im Montageprozess als Ganzes zum Beispiel weiter bearbeitet bzw. eingebaut werden.

In einer vorteilhaften Weiterbildung ist das Sensorelement auf der Trägerplatte montiert und bildet mit dieser eine Baueinheit. Dies vereinfacht den Zusammenbau bzw. die Montage des Berührungs- und/oder Annäherungsschalters insbesondere bei beengten Platzverhältnissen.

In einer bevorzugten Ausführungsform ist auch die Auswerteelektronik der Sensorschaltung auf der Trägerplatte montiert und bildet mit dieser eine Baueinheit.

In einer Ausgestaltung der Erfindung ist der Sensorabschnitt des Sensorelementes in Richtung senkrecht zur Abdeckplatte, d.h. in der Betätigungsrichtung des Berührungs- und/oder Annäherungsschalters elastisch verformbar ausgebildet und/oder angeordnet und/oder befestigt. Auf diese Weise können Bauteil- und Montagetoleranzen ausgeglichen und dadurch die Funktionssicherheit und/oder die Sensitivität des Schalters verbessert werden.

In einer weiteren Ausgestaltung der Erfindung kontaktiert der Sensorabschnitt des Sensorelementes die dem Benutzer abgewandte Seite der Abdeckplatte flächig. Hierdurch kann die Empfindlichkeit des Berührungs- und/oder Annäherungsschalters erhöht werden. Durch eine solche flächige Kontaktierung kann auch eine vordefinierte und gleichmäßige Dicke des Dielektrikums (gebildet durch die Abdeckplatte, keine Luftspalte) gewährleistet werden.

In einer anderen Ausgestaltung der Erfindung ist die Abdeckplatte im Bereich des Berührungsfeldes zumindest teilweise lichtdurchlässig ausgebildet, ist zwischen dem Sensorabschnitt des Sensorelementes und der dem Benutzer abgewandten Seite der Abdeckplatte wenigstens ein Lichtleitelement angeordnet und ist auf der Trägerplatte wenigstens eine Lichtquelle derart angeordnet, dass von der wenigstens einen Lichtquelle ausgesendete Lichtstrahlen in das wenigstens eine Lichtleitelement einkoppeln. Als lichtdurchlässig gelten transluzente Materialien oder auch Durchbrechungen oder Löcher in der Abdecklatte. Auf diese Weise kann das dem Sensorabschnitt entsprechende Berührungsfeld hinterleuchtet bzw. gekennzeichnet werden; außerdem kann dem Benutzer ein Schaltzustand des kapazitiven Berührungs- und/oder Annäherungsschalters signalisiert werden.

Bei dieser Ausführungsform ist vorzugsweise vorgesehen, dass das Lichtleitelement die dem Benutzer abgewandte Seite der Abdeckplatte und/oder die der Abdeckplatte zugewandte Seite des Sensorabschnittes des Sensorelementes flächig kontaktiert. Auf diese Weise kann ein möglichst geringer Abstand zwischen der Abdeckplatte und dem Lichtleitelement bzw. zwischen dem Lichtleitelement und dem Sensorabschnitt und damit insgesamt zwischen der Abdeckplatte und dem Sensorabschnitt des Sensorelementes erzielt werden, was in Bezug auf die Funktionsfähigkeit und die Sensitivität des Schalters vorteilhaft sein kann, da zum Beispiel ein gleichmäßiger und geringer Abstand zwischen der Abdeckplatte und dem Sensorelement und damit ein gleichmäßig dickes Dielektrikum erzielt werden können.

In einer weiteren Ausführungsform liegt der Kontaktabschnitt des Sensorelementes auf wenigstens einer Seite der Trägerplatte an und/oder ragt wenigstens ein Teil des Kontaktabschnitts in ein Loch in der Trägerplatte. Derartiges Zusammenwirken von Kontaktabschnitt und Trägerplatte ermöglicht eine vorteilhafte, robuste Verbindung.

Zweckmäßiger Weise ist der Kontaktabschnitt des Sensorelementes mit der Trägerplatte mittels Steckkontakt, Verstemmen, Verklemmen, Verlöten oder Kleben verbunden.

Der kapazitive Berührungs- und/oder Annäherungsschalter der Erfindung kann in vorteilhafter Weise in einer Bedienvorrichtung, insbesondere einer Bedienvorrichtung eines elektrischen bzw. elektronischen Haushaltsgerätes wie eines Herdes, eines Kochfeldes, eines Mikrowellenofens, einer Spülmaschine, einer Waschmaschine, eines Wäschetrockners und dergleichen eingesetzt werden. Durch die (groß)winklige Anordnung der Trägerplatte relativ zur Abdeckplatte ist dabei in vorteilhafter Weise zum Beispiel auch ein Einsatz für Bedienblenden in einer Stirnseite einer Tür oder einer Seitenwand des Haushaltsgerätes möglich.

Bei dieser Anwendung kann die Bedienvorrichtung auch mehrere kapazitive Berührungs- und/oder Annäherungsschalter aufweisen, die jeweils ein Sensorelement aufweisen, wobei die Sensorelemente dieser mehreren kapazitiven Berührungs- und/oder Annäherungsschalter auf einer gemeinsamen Trägerplatte montiert sind. Die mehreren Berührungs- und/oder Anordnungsschalter sind in diesem Fall bevorzugt im Wesentlichen in einer Reihe angeordnet, um die Montage auf der Trägerplatte zu vereinfachen.

Gemäß einem weiteren Aspekt der vorliegenden Erfindung wird die oben genannte Aufgabe durch ein Verfahren zur Herstellung eines kapazitiven Berührungs- und/oder Annäherungsschalters mit den Merkmalen des Anspruches 13 gelöst.

Gemäß diesem Verfahren wird zunächst eine elektrisch isolierende Abdeckplatte bereitgestellt, die ein Berührungsfeld für einen Benutzer definiert. Dann wird ein elektrisch leitfähiges Sensorelement auf einer Trägerplatte montiert, wobei das Sensorelement einen Sensorabschnitt und einen Kontaktabschnitt zum Befestigen des Sensorelementes auf der Trägerplatte aufweist und eine Auswerteelektronik über den Kontaktabschnitt elektrisch leitend mit dem Sensorelement verbunden ist, sodass die Trägerplatte und das Sensorelement eine Baueinheit bilden. Dabei ist der Kontaktabschnitt des Sensorelementes außerdem zur Ausrichtung des Sensorabschnittes des Sensorelementes gegenüber der Trägerplatte in einem Winkel von etwa 30 Grad bis zu etwa 90 Grad ausgebildet. Schließlich wird die Trägerplatte auf einer dem Benutzer abgewandten Seite der Abdeckplatte in einem Winkel von etwa 30 Grad bis zu etwa 90 Grad zur Abdeckplatte derart angeordnet, dass der Sensorabschnitt des Sensorelementes dem Berührungsfeld korrespondiert und im Wesentlichen parallel zu der Abdeckplatte angeordnet ist und der Kontaktabschnitt des Sensorelementes zur Ausrichtung des Sensorabschnittes des Sensorelementes gegenüber der Trägerplatte in einem Winkel von etwa 30 Grad bis zu etwa 90 Grad ausgebildet ist.

Die Vorteile und bevorzugten Ausgestaltungen dieses Verfahrens entsprechen jenen, die oben in Zusammenhang mit dem erfindungsgemäßen Berührungs- und/oder Annäherungsschalter beschrieben worden sind. Insbesondere kann mit diesem Verfahren ein erfindungsgemäßer Berührungs- und/oder Annäherungsschalter wie oben beschrieben geschaffen werden.

Obige sowie weitere Merkmale, Vorteile und Anwendungsmöglichkeiten der Erfindung werden aus der nachfolgenden Beschreibung bevorzugter, nicht-einschränkender Beispiele unter Bezug auf die beiliegenden Zeichnungen besser verständlich. Darin zeigen:
- Fig. 1: eine schematische Perspektivansicht eines kapazitiven Berührungs- und/oder Annäherungsschalters gemäß einem ersten Ausführungsbeispiel der Erfindung;
- Fig. 2: eine schematische Seitenansicht des Berührungs- und/oder Annäherungsschalters von Fig. 1;
- Fig. 3: eine schematische Perspektivansicht eines kapazitiven Berührungs- und/oder Annäherungsschalters gemäß einem zweiten Ausführungsbeispiel der Erfindung;
- Fig. 4: eine schematische Seitenansicht des Berührungs- und/oder Annäherungsschalters von Fig. 3.
- Fig. 5: eine schematische Perspektivansicht eines kapazitiven Berührungs- und/oder Annäherungsschalters gemäß einem dritten Ausführungsbeispiel der Erfindung;
- Fig. 6: eine schematische Seitenansicht des Berührungs- und/oder Annäherungsschalters von Fig. 5;
- Fig. 7: eine schematische Perspektivansicht eines kapazitiven Berührungs- und/oder Annäherungsschalters gemäß einem vierten Ausführungsbeispiel der Erfindung;
- Fig. 8: eine schematische Seitenansicht des Berührungs- und/oder Annäherungsschalters von Fig. 7;
- Fig. 9: eine schematische Perspektivansicht eines kapazitiven Berührungs- und/oder Annäherungsschalters gemäß einem fünften Ausführungsbeispiel der Erfindung; und
- Fig. 10: eine schematische Seitenansicht des Berührungs- und/oder Annäherungsschalters von Fig. 9;

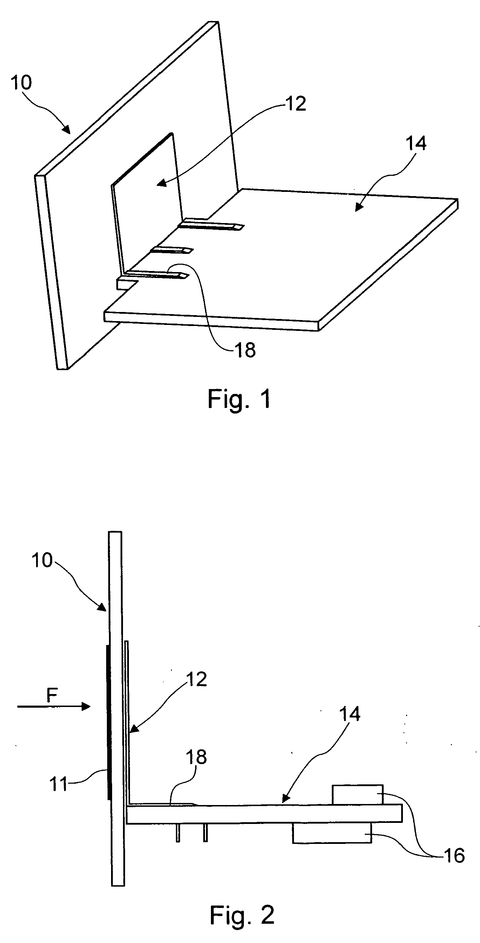

Bezug nehmend auf Fig. 1 und 2 wird nun ein erstes Ausführungsbeispiel eines kapazitiven Berührungs- und/oder Annäherungsschalters in mehr Einzelheiten erläutert. Dieser Berührungs- und/oder Annäherungsschalter kann in vorteilhafter Weise zum Beispiel in einer Bedienvorrichtung für ein elektrisches bzw. elektronisches Haushaltsgerät verwendet werden. Insbesondere kann dieser Berührungs- und/oder Annäherungsschalter zum Beispiel für eine Bedienblende bereitgestellt werden, die in einer Stirnseite einer Tür des Haushaltsgerätes positioniert werden soll.

Der kapazitive Berührungs- und/oder Annäherungsschalter umfasst insbesondere ein hinter einer Abdeckplatte 10 angeordnetes kapazitives Sensorelement. Dieses kapazitive Sensorelement ist auf einer Trägerplatte 14 montiert, welche zum Beispiel eine Leiterplatte oder eine einfache Kunststoffplatte sein kann.

Das kapazitive Sensorelement besteht im Wesentlichen aus einem flächigen Sensorabschnitt 12 aus einem elektrisch leitfähigen Material, der im Wesentlichen parallel zur Abdeckplatte 10 ausgerichtet ist, und einem weiter unten beschriebenen Kontaktabschnitt 18.

Der Sensorabschnitt 12 kann dabei vollflächig ausgebildet sein, wie in Fig. 1 dargestellt, oder eine geschlossene oder offene Ringform mit einem freien Innenraum aufweisen. Während der Sensorabschnitt 12 in Fig. 1 und 2 eine rechteckige Grundform besitzt, sind für das kapazitive Sensorelement grundsätzlich beliebige Grundformen (kreisförmig, elliptisch, quadratisch, mehreckig, scharfe oder abgerundete Ecken, gerade oder gekrümmte Seiten, etc.) möglich. Die Stärke des Sensorabschnittes 12 des Sensorelementes kann von Folienstärke bis zu einer eigenstabilen Plattenstärke reichen.

Die Abmessungen und die Form des Sensorabschnittes 12 des Sensorelementes definieren ein Berührungsfeld 11 auf der Abdeckplatte 10 für den Benutzer. Zum Betätigen des Berührungs- und/oder Annäherungsschalters muss der Benutzer dieses Berührungsfeld 11 auf der dem Benutzer zugewandten Seite (links in Fig. 1 und 2) der Abdeckplatte 10 berühren bzw. sich diesem annähern.

Das Berührungsfeld 11 ist für den Benutzer vorzugsweise gekennzeichnet. Dies kann zum Beispiel durch grafische oder haptische Elemente auf bzw. in der Abdeckplatte 10 erfolgen.

Die Abdeckplatte 10 ist zumindest in dem Bereich dieses Berührungsfeldes 11 aus einem elektrisch isolierenden Material (z.B. Glas, Keramik, Kunststoff) gebildet. Auf diese Weise bildet die Abdeckplatte 10 ein Dielektrikum zwischen dem Sensorabschnitt 12 des Sensorelementes und z.B. einem Finger des Benutzers für den kapazitiven Sensor.

Die Funktionsweise eines solchen kapazitiven Sensors eines Berührungs- und/oder Annäherungsschalters ist dem Fachmann hinlänglich bekannt und nicht Gegenstand dieser Anmeldung. Es kann daher auf eine detaillierte Erläuterung verzichtet werden.

Der Sensorabschnitt 12 ist über den elektrisch leitfähigen Kontaktabschnitt 18 mit einer Auswerteelektronik 16 verbunden, die ein Betätigen bzw. Nicht-Betätigen des Berührungs- und/oder Annäherungsschalters anhand des Ausgangssignals der Sensorschaltung erkennt. Der Kontaktabschnitt 18 ist vorzugsweise integraler Bestandteil des Sensorelementes und dient der Befestigung des Sensorelementes auf einer Trägerplatte 14. Das Sensorelement 12, 18 kann zum Beispiel in einer Stanzbiegetechnik als integrales Bauteil gefertigt werden und bildet nach der Montage auf der Trägerplatte 14 eine integrale Baueinheit.

In dem Ausführungsbeispiel von Fig. 1 und 2 ist der Kontaktabschnitt 18 des Sensorelementes an einer Seite des Sensorabschnittes 12 vorgesehen, insbesondere an der der Trägerplatte 14 zugewandten Seite des Sensorabschnittes 12. Außerdem ist der Kontaktabschnitt 18 des Sensorelementes derart ausgebildet, dass das Sensorelement so an einer Trägerplatte 14 befestigt werden kann, dass der Sensorabschnitt 12 des Sensorelementes in einem Winkel zur Trägerplatte 14 orientiert ist. In diesem Ausführungsbeispiel beträgt dieser Winkel etwa 90 Grad, d.h. der Sensorabschnitt 12 des Sensorelementes verläuft im Wesentlichen senkrecht zur Trägerplatte 14. Dies wird in diesem Ausführungsbeispiel beispielhaft durch den Knick / den Übergang zwischen dem Sensorabschnitt 12 und dem Kontaktabschnitt 18 im entsprechenden Winkel erreicht. Diese Biegung erzeugt auch eine gewisse Elastizität des Sensorelementes.

Fig. 2 zeigt einen Kontaktabschnitt 18, der sowohl auf einer Seite der Trägerplatte 14 anliegt als auch in ein Loch der Trägerplatte 14 hineinragt, im gezeigten Fall durch das Loch hindurch geführt ist.

Die oben genannte Auswerteelektronik 16 ist ebenfalls auf der Trägerplatte 14 angeordnet. Die Auswerteelektronik 16 ist üblicherweise mit der Steuerung (nicht dargestellt) des Haushaltsgerätes verbunden. Diese Steuerung kann wahlweise ebenfalls auf der Trägerplatte 14 angeordnet sein oder an einer anderen geeigneten Stelle im Haushaltsgerät angebracht sein. Falls die Steuerung auf der Trägerplatte 14 vorgesehen ist, kann die Auswerteelektronik 16 in diese Steuerung mit integriert sein.

Wie in Fig. 1 und 2 dargestellt, ist die Trägerplatte 14 im Wesentlichen senkrecht zur Abdeckplatte 10 ausgerichtet, d.h. nicht parallel zu der Abdeckplatte 10 angeordnet. Auf diese Weise kann die Anordnung aus Sensorelement 12, 18 und Trägerplatte 14 mit Auswerteelektronik 16 hinter einer relativ kleinen Bedienblendenfläche der Abdeckplatte 10 angeordnet werden. Es muss lediglich ein ausreichend tiefer Bauraum hinter der Abdeckplatte 10 zur Verfügung stehen.

Die Trägerplatte 14 kann wahlweise an der Abdeckplatte 10 und/oder an anderen Elementen der Bedienblende hinter der Abdeckplatte 10 in der gewünschten Ausrichtung befestigt werden.

In dem Ausführungsbeispiel von Fig. 1 und 2 steht der Sensorabschnitt 12 des kapazitiven Sensorelementes mit der dem Benutzer abgewandten Seite der Abdeckplatte 10 (rechts in Fig. 1 und 2) (voll-)flächig in Kontakt. Auf diese Weise wird ein gleichmäßiger und geringer Abstand zur Abdeckplatte 10 gewährleistet, was für die Funktionsfähigkeit und - sicherheit des kapazitiven Berührungs- und/oder Annäherungsschalters von Vorteil ist.

Im Fall dieser flächigen Kontaktierung ist der Sensorabschnitt 12 vorzugsweise auch mit der Abdeckplatte 10 fest verbunden.

Zur Verbesserung der Funktionsfähigkeit und -sicherheit des kapazitiven Berührungs- und/oder Annäherungsschalters kann der elektrisch leitfähige Sensorabschnitt 12 in Richtung senkrecht zur Abdeckplatte 10, d.h. in der Hauptbetätigungsrichtung F (vgl. Fig. 2) des Schalters, elastisch verformbar ausgebildet / angeordnet / befestigt sein. Auf diese Weise können Bauteiltoleranzen, Montagetoleranzen und Positionsveränderungen über die Lebensdauer des Schalters ausgeglichen werden und ein gleichbleibend gleichmäßiger Abstand bzw. eine gleichbleibende Kontaktierung zwischen dem Sensorabschnitt 12 des Sensorelementes und der Abdeckplatte 10 gewährleistet werden. Eine derartige Elastizität wird hier zum Beispiel durch den Übergang zwischen dem Sensorabschnitt 12 und dem Kontaktabschnitt 18 des Sensorelementes bewirkt.

Soll die Bedienvorrichtung des Haushaltsgerätes mehrere solcher kapazitiven Berührungs- und/oder Annäherungsschalter enthalten, so können diese, falls sie im Wesentlichen entlang einer Reihe angeordnet sind, auf einer einzigen gemeinsamen Trägerplatte 14 als Baueinheit bereitgestellt werden. D.h. die nebeneinander angeordneten kapazitiven Sensorelemente sind über ihre elektrischen Kontaktabschnitte 18 mit einer oder mehreren Auswerteelektroniken 16 auf einer gemeinsamen Trägerplatte 14 hinter der Abdeckung 10 verbunden.

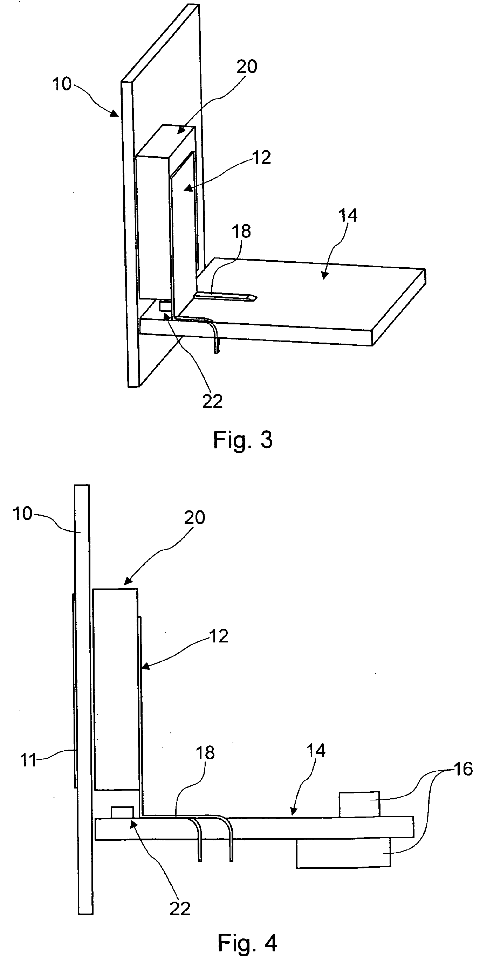

Bezug nehmend auf Fig. 3 und 4 wird nun ein zweites Ausführungsbeispiel eines Berührungs- und/oder Annäherungsschalters näher beschrieben. Dabei sind gleiche bzw. entsprechende Komponenten mit den gleichen Bezugsziffern wie im ersten Ausführungsbeispiel gekennzeichnet.

Der Berührungs- und/oder Annäherungsschalter dieses Ausführungsbeispiels unterscheidet sich von dem in Fig. 1 und 2 dargestellten Schalter durch die Möglichkeit der Hinterleuchtung bzw. Kennzeichnung des Berührungsfeldes.

Zu diesem Zweck ist der Sensorabschnitt 12 des elektrisch leitfähigen Sensorelementes im Wesentlichen parallel zu der Abdeckplatte 10 in einem Abstand hinter dieser angeordnet. Zwischen die dem Benutzer abgewandte Seite der Abdeckplatte 10 und den Sensorabschnitt 12 ist dann ein Lichtleitelement 20 gesetzt.

Vorzugsweise ist einerseits das Lichtleitelement 20 mit der Abdeckplatte 10 flächig verbunden und an dieser befestigt und andererseits der Sensorabschnitt 12 des Sensorelementes mit der der Abdeckplatte 10 abgewandten Seite des Lichtleitelementes 20 flächig verbunden und an diesem befestigt. Alternativ können zwischen den Komponenten 10 / 20 und/oder 20 / 12 auch geringe Abstände vorgesehen sein, um z.B. unterschiedliche thermische Ausdehnungskoeffizienten der Materialien berücksichtigen zu können. In einer weiteren Alternative liegt eine Mischform der beiden vorgenannten Alternativen vor. Beispielsweise ist zwischen den Komponenten 10 / 20 ein geringer Abstand vorgesehen und der Sensorabschnitt 12 des Sensorelementes ist mit der der Abdeckplatte 10 abgewandten Seite des Lichtleitelementes 20 flächig verbunden und an diesem oder an der Trägerplatte 14 befestigt

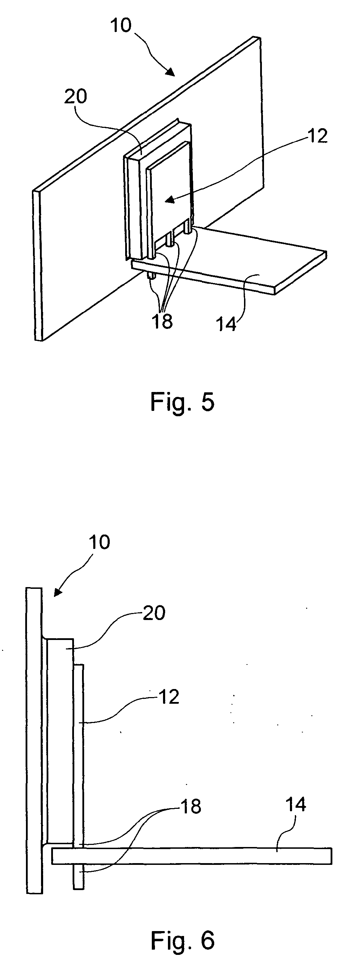

In einer Variante dieses Ausführungsbeispiels kann das Lichtleitelement 20 elastisch verformbar ausgebildet / angeordnet / befestigt sein. Beispiele hierzu sind in den Fig. 5 bis 10 beschrieben.

Auf der Trägerplatte 14 ist zudem wenigstens eine Lichtquelle 22 zum Beispiel in Form einer Leuchtdiode (LED) vorgesehen. Diese wenigstens eine Lichtquelle 22 ist so angeordnet und ausgerichtet, das die von ihr ausgesendeten Lichtstrahlen in eine Seite des Lichtleitelementes 20 einkoppeln können.

Die Lichtquelle 22 und das Lichtleitelement 20 können ebenfalls mit der Trägerplatte 14 eine Baueinheit bilden. Alternativ bildet das Lichtleitelement 20 mit der Abdeckplatte 10 eine Baueinheit.

Außerdem ist die Abdeckplatte 10 im Bereich des Berührungsfeldes 11 zumindest teilweise lichtdurchlässig ausgebildet. In einer alternativen Variante weist die Abdeckplatte 10 im Bereich des Berührungsfeldes 11 wenigstens eine Durchbrechung oder ein Loch auf, hinter dem das Lichtleitelement 20 angeordnet ist. Das Lichtleitelement 20 kann so in die Durchbrechung oder das Loch eingepasst sein, dass Lichtleitelement 20 mit dem Niveau der Berührfläche des Berührungsfeldes 11 zusammenfällt. Auf diese Weise kann das Berührungsfeld 11 des Schalters hinterleuchtet oder gekennzeichnet werden oder es können die Schaltzustände des Berührungs- und/oder Annäherungsschalters signalisiert werden. Die wenigstens eine Lichtquelle 22 kann zum Beispiel in unterschiedlichen Betriebsmodi (aus, Dauerlicht, Blinklicht) angesteuert werden oder mehrere Lichtquellen in unterschiedlichen Farben umfassen. Die Ansteuerung der wenigstens einen Lichtquelle 22 erfolgt vorzugsweise über die auf der Trägerplatte 14 angeordnete Auswerteelektronik 16 der Sensorschaltung.

Die weiteren Komponenten, Merkmale, Vorteile und Varianten entsprechen jenen des obigen Ausführungsführungsbeispiels von Fig. 1 und 2.

Bezug nehmend auf Fig. 5 und 6 wird nun ein Aspekt eines dritten Ausführungsbeispiels eines Berührungs- und/oder Annäherungsschalters näher beschrieben. Die übrigen Aspekte entsprechen denen der vorhergehenden Ausführungsbeispiele. Dabei sind gleiche bzw. entsprechende Komponenten mit den gleichen Bezugsziffern wie im ersten Ausführungsbeispiel gekennzeichnet.

In diesem Ausführungsbeispiel geht der Kontaktabschnitt 18 des Sensorelementes geradlinig aus dem Sensorabschnitt 12 hervor und durchdringt das durchgängige Loch in der Trägerplatte 14. Alternativ könnte der Kontaktabschnitt 18 in das Loch in der Trägerplatte 14 nur hineinragen. Anstelle eines durchgängigen Lochs könnte ein Sackloch vorgesehen sein.

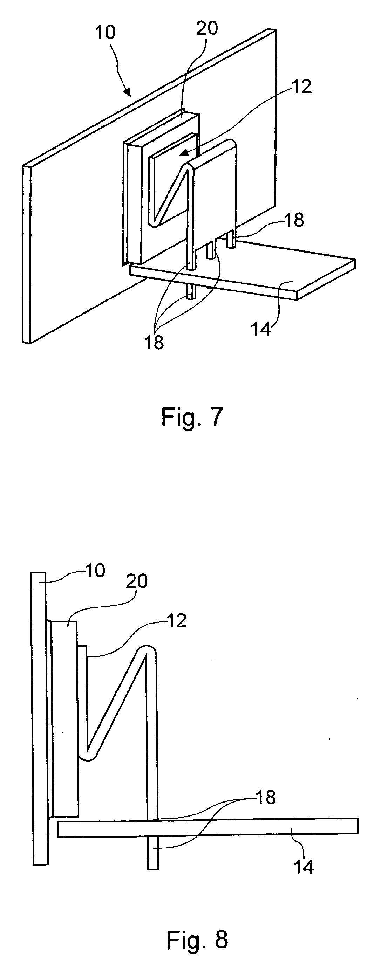

Bezug nehmend auf Fig. 7 und 8 wird nun ein Aspekt eines dritten Ausführungsbeispiels eines Berührungs- und/oder Annäherungsschalters näher beschrieben. Die übrigen Aspekte entsprechen denen der vorhergehenden Ausführungsbeispiele. Dabei sind gleiche bzw. entsprechende Komponenten mit den gleichen Bezugsziffern wie im ersten Ausführungsbeispiel gekennzeichnet.

Zur Verbesserung der Funktionsfähigkeit und -sicherheit des kapazitiven Berührungs- und/oder Annäherungsschalters kann der elektrisch leitfähige Sensorabschnitt 12 des z-förmigen Sensorelements in Richtung senkrecht zur Abdeckplatte 10, d.h. in der Hauptbetätigungsrichtung F (vgl. Fig. 2) des Schalters, elastisch verformbar ausgebildet / angeordnet / befestigt sein. Auf diese Weise können Bauteiltoleranzen, Montagetoleranzen und Positionsveränderungen über die Lebensdauer des Schalters ausgeglichen werden und ein gleichbleibend gleichmäßiger Abstand bzw. eine gleichbleibende Kontaktierung zwischen dem Sensorabschnitt 12 des Sensorelementes und der Abdeckplatte 10 gewährleistet werden. Eine derartige Elastizität wird hier zum Beispiel durch den Übergang zwischen dem Sensorabschnitt 12 und dem Kontaktabschnitt 18 des Sensorelementes bewirkt.

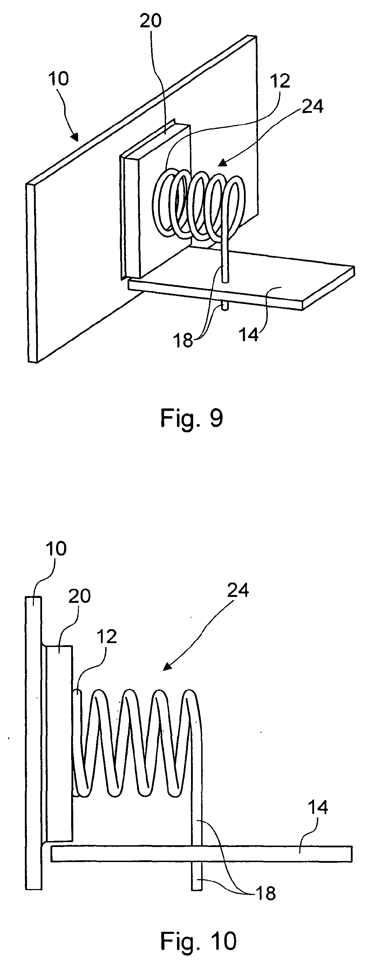

Bezug nehmend auf Fig. 9 und 10 wird nun ein Aspekt eines vierten Ausführungsbeispiels eines Berührungs- und/oder Annäherungsschalters näher beschrieben. Die übrigen Aspekte entsprechen denen der vorhergehenden Ausführungsbeispiele. Dabei sind gleiche bzw. entsprechende Komponenten mit den gleichen Bezugsziffern wie im ersten Ausführungsbeispiel gekennzeichnet.

Das Sensorelement ist durch eine Druckfeder 24 gebildet, deren erste Windung der Sensorabschnitt 12 des Sensorelements ist. Alternativ könnte der Sensorabschnitt 12 auch durch einen Teil der ersten Windung gebildet sein. Der Kontaktabschnitt 18 des Sensorelements durchdringt das durchgängige Loch in der Trägerplatte 14. In einer alternativen Ausführungsform könnte die letzte Windung der Druckfeder 24 auf einer Seite der Trägerplatte anliegen, die Druckfeder wäre gegenüber ihrer Längsachse verbogen.

Eine weiteres, nicht gezeigtes Ausführungsbeispiel stellt ein Sensorelement dar, das aus elastischem Kunststoff gebildet ist, wobei das Sensorelement leitfähig ist oder eine leitfähige Beschichtung bzw. leitfähige Ummantelung aufweist.

## Patentansprüche

1. Kapazitiver Berührungs- und/oder Annäherungsschalter, mit einer elektrisch isolierenden Abdeckplatte (10), welche ein Berührungsfeld (11) für einen Benutzer definiert, einer auf einer dem Benutzer abgewandten Seite der Abdeckplatte (10) angeordneten Trägerplatte (14), einem elektrisch leitfähigen Sensorelement (12, 18) und einer Auswerteelektronik (16), welche elektrisch leitend mit dem Sensorelement (12, 18) verbunden ist, wobei
das Sensorelement (12, 18) einen Sensorabschnitt (12), der auf der dem Benutzer abgewandten Seite der Abdeckplatte (10) korrespondierend zu dem Berührungsfeld (11) und im Wesentlichen parallel zu der Abdeckplatte (10) angeordnet ist, und einen Kontaktabschnitt (18) zum Befestigen des Sensorelementes an der Trägerplatte (14) aufweist,
die Auswerteelektronik (16) über den Kontaktabschnitt (18) elektrisch leitend mit dem Sensorelement (12, 18) verbunden ist,
das Sensorelement (12, 18) mit der Trägerplatte (14) verbunden ist und
die Trägerplatte (14) in einem Winkel von etwa 30 Grad bis zu etwa 90 Grad zur Abdeckplatte (10) angeordnet ist und der Kontaktabschnitt (18) des Sensorelementes (12, 18) zur Ausrichtung des Sensorabschnittes (12) des Sensorelementes (12, 18) gegenüber der Trägerplatte (14) in einem Winkel von etwa 30 Grad bis zu etwa 90 Grad ausgebildet ist.

2. Berührungs- und/oder Annäherungsschalter nach Anspruch 1,
**dadurch gekennzeichnet,**
**dass** die Trägerplatte (14) im Wesentlichen senkrecht zu der Abdeckplatte (10) angeordnet ist.

3. Berührungs- und/oder Annäherungsschalter nach Anspruch 1 oder 2,
**dadurch gekennzeichnet,**
**dass** das Sensorelement (12, 18) auf der Trägerplatte (14) montiert ist und mit dieser eine Baueinheit bildet.

4. Berührungs- und/oder Annäherungsschalter nach einem der vorherigen Ansprüche,
**dadurch gekennzeichnet,**
**dass** die Auswerteelektronik (16) auf der Trägerplatte (14) montiert ist und mit dieser eine Baueinheit bildet.

5. Berührungs- und/oder Annäherungsschalter nach einem der vorherigen Ansprüche,
**dadurch gekennzeichnet,**
**dass** der Sensorabschnitt (12) des Sensorelementes (12, 18) in Richtung senkrecht zu der Abdeckplatte (10) elastisch verformbar ausgebildet und / oder angeordnet und/oder befestigt ist.

6. Berührungs- und/oder Annäherungsschalter nach einem der vorherigen Ansprüche,
**dadurch gekennzeichnet,**
**dass** der Sensorabschnitt (12) des Sensorelementes (12, 18) die dem Benutzer abgewandte Seite der Abdeckplatte (10) flächig kontaktiert.

7. Berührungs- und/oder Annäherungsschalter nach einem der Ansprüche 1 bis 6,
**dadurch gekennzeichnet,**
**dass** die Abdeckplatte (10) im Bereich des Berührungsfeldes (11) zumindest teilweise lichtdurchlässig ausgebildet ist;
**dass** zwischen dem Sensorabschnitt (12) des Sensorelementes (12, 18) und der dem Benutzer abgewandten Seite der Abdeckplatte (10) wenigstens ein Lichtleitelement (20) angeordnet ist; und
**dass** auf der Trägerplatte (14) wenigstens eine Lichtquelle (22) derart angeordnet ist, dass von der wenigstens einen Lichtquelle (22) ausgesendete Lichtstrahlen in das wenigstens eine Lichtleitelement (20) einkoppeln.

8. Berührungs- und/oder Annäherungsschalter nach Anspruch 7,
**dadurch gekennzeichnet,**
**dass** das Lichtleitelement (20) die dem Benutzer abgewandte Seite der Abdeckplatte (10) und/oder die der Abdeckplatte (10) zugewandte Seite des Sensorabschnittes (12) des Sensorelementes (12, 18) flächig kontaktiert.

9. Berührungs- und/oder Annäherungsschalter nach einem der Ansprüche 1 bis 8,
**dadurch gekennzeichnet,**
**dass** der Kontaktabschnitt (18) des Sensorelementes (12, 18) auf wenigstens einer Seite der Trägerplatte (14) anliegt und/oder der Kontaktabschnitt (18) in ein Loch in der Trägerplatte (14) ragt.

10. Berührungs- und/oder Annäherungsschalter nach einem der Ansprüche 1 bis 9,
**dadurch gekennzeichnet,**
**dass** der Kontaktabschnitt (18) des Sensorelementes (12, 18) mit der Trägerplatte (14) mittels Steckkontakt, Verstemmen, Verklemmen, Verlöten oder Kleben verbunden ist.

11. Bedienvorrichtung, insbesondere für ein elektronisches Haushaltsgerät, mit wenigstens einem kapazitiven Berührungs- und/oder Annäherungsschalter nach einem der Ansprüche 1 bis 10.

12. Bedienvorrichtung nach Anspruch 11,
**dadurch gekennzeichnet,**
**dass** die Bedienvorrichtung mehrere kapazitive Berührungs- und/oder Annäherungsschalter aufweist, die jeweils ein Sensorelement (12, 18) aufweisen, wobei die Sensorelemente (12, 18) der mehreren kapazitiven Berührungs- und/oder Annäherungsschalter auf einer gemeinsamen Trägerplatte (14) montiert sind.

13. Verfahren zur Herstellung eines kapazitiven Berührungs- und/oder Annäherungsschalters, mit den Schritten:
Bereitstellen einer elektrisch isolierenden Abdeckplatte (10), welche ein Berührungsfeld (11) für einen Benutzer definiert,
Montieren eines elektrisch leitfähigen Sensorelementes (12, 18) auf einer Trägerplatte (14), wobei das Sensorelement (12, 18) einen Sensorabschnitt (12) und einen Kontaktabschnitt (18) zum Befestigen des Sensorelementes an der Trägerplatte (14) aufweist und eine Auswerteelektronik (16) über den Kontaktabschnitt (18) elektrisch leitend mit dem Sensorelement (12, 18) verbunden ist, sodass die Trägerplatte (14) und das Sensorelement (12, 18) eine Baueinheit bilden,
Anordnen der Trägerplatte (14) auf einer dem Benutzer abgewandten Seite der Abdeckplatte (10) in einem Winkel von etwa 30 Grad bis zu etwa 90 Grad zur Abdeckplatte (10) derart, dass der Sensorabschnitt (12) des Sensorelementes (12, 18) dem Berührungsfeld (11) korrespondiert und im Wesentlichen parallel zu der Abdeckplatte (10) angeordnet ist und der Kontaktabschnitt (18) des Sensorelementes (12, 18) zur Ausrichtung des Sensorabschnittes (12) des Sensorelementes (12, 18) gegenüber der Trägerplatte (14) in einem Winkel von etwa 30 Grad bis zu etwa 90 Grad ausgebildet ist.

## Claims

1. Capacitive touch and/or proximity switch having an electrically insulating covering plate (10) which defines a touch panel (11) for a user, a carrier plate (14) arranged on a side of the covering plate (10) facing away from the user, an electrically conductive sensor element (12, 18) and evaluation electronics (16) which are connected to the sensor element (12, 18) in an electrically conductive manner,
the sensor element (12, 18) having a sensor section (12), which is arranged on that side of the covering plate (10) which faces away from the user in a manner corresponding to the touch panel (11) and substantially parallel to the covering plate (10), and a contact section (18) for fastening the sensor element to the carrier plate (14),
the evaluation electronics (16) being connected to the sensor element (12, 18) in an electrically conductive manner via the contact section (18),
the sensor element (12, 18) being connected to the carrier plate (14), and
the carrier plate (14) being arranged at an angle of approximately 30 degrees to approximately 90 degrees with respect to the covering plate (10), and the contact section (18) of the sensor element (12, 18) being designed to orient the sensor section (12) of the sensor element (12, 18) with respect to the carrier plate (14) at an angle of approximately 30 degrees to approximately 90 degrees.

2. Touch and/or proximity switch according to Claim 1,
**characterized in that**
the carrier plate (14) is arranged substantially perpendicular.to the covering plate (10).

3. Touch and/or proximity switch according to Claim 1 or 2,
**characterized in that**
the sensor element (12, 18) is mounted on the carrier plate (14) and forms a structural unit with the latter.

4. Touch and/or proximity switch according to one of the preceding claims,
**characterized in that**
the evaluation electronics (16) are mounted on the carrier plate (14) and form a structural unit with the latter.

5. Touch and/or proximity switch according to one of the preceding claims,
**characterized in that**
the sensor section (12) of the sensor element (12, 18) is designed and/or arranged and/or fastened in an elastically deformable manner in a direction perpendicular to the covering plate (10).

6. Touch and/or proximity switch according to one of the preceding claims,
**characterized in that**
the sensor section (12) of the sensor element (12, 18) makes areal contact with that side of the covering plate (10) which faces away from the user.

7. Touch and/or proximity switch according to one of Claims 1 to 6,
**characterized in that**
the covering plate (10) is at least partially translucent in the region of the touch panel (11); **in that** at least one light guiding element (20) is arranged between the sensor section (12) of the sensor element (12, 18) and that side of the covering plate (10) which faces away from the user; and
**in that** at least one light source (22) is arranged on the carrier plate (14) in such a manner that light beams emitted by the at least one light source (22) are coupled into the at least one light guiding element (20).

8. Touch and/or proximity switch according to Claim 7.
**characterized in that**
the light guiding element (20) makes areal contact with that side of the covering plate (10) which faces away from the user and/or that side of the sensor section (12) of the sensor element (12, 18) which faces the covering plate (10).

9. Touch and/or proximity switch according to one of Claims 1 to 8,
**characterized in that**
the contact section (18) of the sensor element (12, 18) rests on at least one side of the carrier plate (14) and/or the contact section (18) projects into a hole in the carrier plate (14).

10. Touch and/or proximity switch according to one of Claims 1 to 9,
**characterized in that**
the contact section (18) of the sensor element (12, 18) is connected to the carrier plate (14) by means of a plug-in contact, caulking, clamping, soldering or adhesive bonding.

11. Operating device, in particular for an electronic household appliance, having at least one capacitive touch and/or proximity switch according to one of Claims 1 to 10.

12. Operating device according to Claim 11,
**characterized in that**
the operating device has a plurality of capacitive touch and/or proximity switches each having a sensor element (12, 18), the sensor elements (12, 18) of the plurality of capacitive touch and/or proximity switches being mounted on a common carrier plate (14).

13. Method for producing a capacitive touch and/or proximity switch, having the steps of:
providing an electrically insulating covering plate (10) which defines a touch panel (11) for a user,
mounting an electrically conductive sensor element (12, 18) on a carrier plate (14), the sensor element (12, 18) having a sensor section (12) and a contact section (18) for fastening the sensor element to the carrier plate (14), and evaluation electronics (16) being connected to the sensor element (12, 18) in an electrically conductive manner via the contact section (18), with the result that the carrier plate (14) and the sensor element (12, 18) form a structural unit,
arranging the carrier plate (14) on a side of the covering plate (10) facing away from the user at an angle of approximately 30 degrees to approximately 90 degrees with respect to the covering plate (10) in such a manner that the sensor section (12) of the sensor element (12, 18) corresponds to the touch panel (11) and is arranged substantially parallel to the covering plate (10), and the contact section (18) of the sensor element (12, 18) is designed to orient the sensor section (12) of the sensor element (12, 18) with respect to the carrier plate (14) at an angle of approximately 30 degrees to approximately 90 degrees.

## Revendications

1. Commutateur de contact et/ou de rapprochement capacitif avec une plaque de couverture électriquement isolante (10), laquelle définit un champ de contact (11) pour un utilisateur, une plaque porteuse (14) disposée sur un côté de la plaque de couverture (10) opposé à l'utilisateur, un élément de détection électroconducteur (12, 18) et un système électronique d'évaluation (16), lequel est relié de manière électroconductrice à l'élément de détection (12, 18), pour lequel
l'élément de détection (12, 18) comporte une section de détection (12) qui est disposée sur le côté de la plaque de couverture (10) opposé à l'utilisateur, correspondant au champ de contact (11) et pour l'essentiel parallèlement à la plaque de couverture (10) et une section de contact (18) pour fixer l'élément de détection à la plaque porteuse (14),
le système électronique d'évaluation (16) est relié par le biais de la section de contact (18) de manière électroconductrice à l'élément de détection (12, 18),
l'élément de détection (12, 18) est relié à la plaque porteuse (14), et
la plaque porteuse (14) est disposée dans un angle d'environ 30 degrés usqu' à environ 90 degrés par rapport à la plaque de couverture (10) et la section de contact (18) de l'élément de détection (12, 18) est constituée pour l'orientation de la section de détection (12) de l'élément de détection (12, 18) par rapport à la plaque porteuse (14) dans un angle d'environ 30 degrés jusqu'à environ 90 degrés.

2. Commutateur de contact et/ou de rapprochement selon la revendication 1
**caractérisé en ce que**
la plaque porteuse (14) est disposée pour l'essentiel perpendiculairement à la plaque de couverture (10).

3. Commutateur de contact et/ou de rapprochement selon la revendication 1 ou 2
**caractérisé en ce que**
l'élément de détection (12, 18) est monté sur la plaque porteuse (14) et forme avec celle-ci une unité modulaire.

4. Commutateur de contact et/ou de rapprochement selon l'une quelconque des revendications précédentes
**caractérisé en ce que**
le système électronique d'évaluation (16) est monté sur la plaque porteuse (14) et forme avec celle-ci une unité modulaire.

5. Commutateur de contact et/ou de rapprochement selon l'une quelconque des revendications précédentes
**caractérisé en ce que**
la section de détection (12) de l'élément de détection (12, 18) est constituée et/ou disposée et/ou fixée par déformation élastique dans une direction perpendiculaire à la plaque de couverture (10).

6. Commutateur de contact et/ou de rapprochement selon l'une quelconque des revendications précédentes
**caractérisé en ce que**
la section de détection (12) de l'élément de détection (12, 18) est en contact de manière plane avec le côté de la plaque de couverture (10) opposé à l'utilisateur.

7. Commutateur de contact et/ou de rapprochement selon l'une quelconque des revendications 1 à 6
**caractérisé en ce que**
la plaque de couverture (10) est constituée dans la zone du champ de contact (11) au moins en partie de manière transparente ;
**en ce qu'**au moins un élément de guidage de lumière (20) est disposé entre la section de détection (12) de l'élément de détection (12, 18) et le côté de la plaque de couverture (10) opposé à l'utilisateur ; et
**en ce que** sur la plaque porteuse (14) est disposée au moins une source lumineuse (22) de telle manière que des rayons lumineux émis par l'au moins une source lumineuse (22) sont injectés dans l'au moins un élément de guidage de lumière (20).

8. Commutateur de contact et/ou de rapprochement selon la revendication 7
**caractérisé en ce que**
l'élément de guidage de lumière (20) vient en contact de manière plane avec le côté de la plaque de couverture (10) opposé à l'utilisateur et/ou le côté de la section de détection (12) de l'élément de détection (12, 18) tourné vers la plaque de couverture (10).

9. Commutateur de contact et/ou de rapprochement selon l'une quelconque des revendications 1 à 8
**caractérisé en ce que**
la section de contact (18) de l'élément de détection (12, 18) vient s'appuyer sur au moins un côté de la plaque porteuse (14) et/ou la section de contact (18) dépasse dans un trou dans la plaque porteuse (14).

10. Commutateur de contact et/ou de rapprochement selon l'une quelconque des revendications 1 à 9
**caractérisé en ce que**
la section de contact (18) de l'élément de détection (12, 18) est reliée à la plaque porteuse (14) au moyen d'un contact à fiches, par matage, serrage, brasage ou collage.

11. Commande de réglage, en particulier pour un appareil ménager électronique, avec au moins un commutateur de contact et/ou de rapprochement capacitif selon l'une quelconque des revendications 1 à 10.

12. Commande de réglage selon la revendication 11
**caractérisé en ce que**
la commande de réglage comporte plusieurs commutateurs de contact et/ou de rapprochement capacitifs qui comportent respectivement un élément de détection (12, 18), les éléments de détection (12, 18) des plusieurs commutateurs de contact et/ou de rapprochement capacitifs étant montés sur une plaque porteuse commune (14).

13. Procédé destiné à la fabrication d'un commutateur de contact et/ou de rapprochement capacitif comportant les étapes suivantes :
préparation d'une plaque de couverture électriquement isolante (10), laquelle définit un champ de contact (11) pour un utilisateur,
montage d'un élément de détection électroconducteur (12, 18) sur une plaque porteuse (14), l'élément de détection (12, 18) comportant une section de détection (12) et une section de contact (18) pour fixer l'élément de détection à la plaque porteuse (14) et un système électronique d'évaluation (16) étant relié de manière électroconductrice par la section de contact (18) à l'élément de détection (12, 18), de sorte que la plaque porteuse (14) et l'élément de détection (12, 18) forment une unité modulaire,
mise en place de la plaque porteuse (14) sur un côté de la plaque de couverture (10) opposé à l'utilisateur dans un angle d'environ 30 degrés jusqu'à environ 90 degrés par rapport à la plaque de couverture (10) de telle manière que la section de détection (12) de l'élément de détection (12, 18) correspond au champ de contact (11) et est disposée pour l'essentiel parallèlement à la plaque de couverture (10) et la section de contact (18) de l'élément de détection (12, 18) est constituée pour l'orientation de la section de détection (12) de l'élément de détection (12, 18) par rapport à la plaque porteuse (14) dans un angle d'environ 30 degrés jusqu'à environ 90 degrés.
